# EUROPEAN PATENT APPLICATION

(11) **EP 3 199 661 A1**
(43) Date of publication of application: **02.08.2017**
(21) Application number: 15844159.2
(22) Date of filing: 15.07.2015
(51) Int. Cl.: C23C 14/34, H01L 43/12

(54) **SPUTTERING DEVICE**

(30) Priority: 24.09.2014 JP 2014193608
(71) Applicant: ULVAC, Inc., Chigasaki-shi, Kanagawa 253-8543 (JP)
(72) Inventor: YAMAMOTO, Hiroki, Chigasaki-shi Kanagawa 253-8543 (JP); NANBA, Takahiro, Chigasaki-shi Kanagawa 253-8543 (JP); KAMII, Masanobu, Chigasaki-shi Kanagawa 253-8543 (JP); KOHARI, Shinji, Chigasaki-shi Kanagawa 253-8543 (JP); KONDO, Tomoyasu, Chigasaki-shi Kanagawa 253-8543 (JP); MORIMOTO, Naoki, Chigasaki-shi Kanagawa 253-8543 (JP)
(74) Representative: Epping - Hermann - Fischer
(86) International application number: PCT/JP2015/003575
(87) International publication number: WO 2016/047013

(57) **Abstract**

There is provided a sputtering apparatus which is capable of forming, with good uniformity of film thickness distribution, an insulator film having further improved crystallinity. Inside a vacuum chamber 1 in which is provided an insulator target 4, there is disposed a stage 2 for holding a substrate W to be processed so as to face the insulator target. The sputtering apparatus has: a driving means 3 for driving to rotate the stage; a sputtering power source E1 for applying HF power to the insulator target; and a gas introduction means 13, 14 for introducing a rage gas into the vacuum chamber. The sputtering apparatus is characterized in that a distance d3 between the substrate and the insulator target is set to a range between 40 mm - 150 mm.

## Description

### Technical Field

The present invention relates to a sputtering apparatus for forming a film made of an insulating material such as magnesium oxide film and the like.

### Background Art

Attention has recently been paid to a Magnetic Random Access Memory (MRAM) which employs Magnetic Tunnel Junction (MTJ) elements by utilizing Tunneling Magneto Resistance (TMR) effect. Then, as such a tunnel barrier layer of the MTJ elements as is made by sandwiching the tunnel barrier layer by means of electrode layers of two ferromagnetic materials, it is being contemplated to use crystalline magnesium oxide (MgO) films. In order to improve the properties of this kind of MTJ elements, one of the important elements is the rate of change in magnetic resistance (rate of change: MR ratio between the tunnel resistance (R_{P}) when the magnetization of electrode layers on both sides is parallel with each other, and the tunnel resistance (R_{AP}) when the magnetization of electrode layers on both sides is antiparallel with each other). In order to improve the MR ratio to the best extent possible, it is generally known to require the improvement in the structure of the interface between the electrode layer and the tunnel barrier layer (e.g., a state in which O or O₂ does not remain excessively in the interface, and the like) and the improvement in the crystallinity of magnesium oxide. On the other hand, it is being required that the film-forming apparatus for forming the above-mentioned magnesium oxide film has the capability of forming the film such that the in-plane film thickness distribution in the substrate to be processed (e.g., silicon wafer of Φ 300 mm in diameter) becomes 1 σ < 1%.

As a film forming apparatus that can form this kind of magnesium oxide film, the following sputtering apparatus is known in Patent Document 1. The apparatus is provided, in a bottom portion of a vacuum chamber in which a target made of magnesium oxide is disposed, with: a stage for holding thereon a substrate in a manner to face the target; a sputtering power source for applying HF power to the insulator target; and a gas introduction means for introducing a rare gas into the vacuum chamber. Then, the stage is provided with a driving means for driving to rotate the stage about the center of the stage. At the same time, the target to be disposed on an upper portion of the vacuum chamber is constituted by dividing it into a first target material, and a second target material which is smaller in area than the first target material. Both the first and the second target materials are arranged in an inclined manner relative to the surface of the substrate (film-forming surface). In this case, in order to reduce local defects on the magnesium oxide film due to oxygen ions, e.g., at the time of film formation, it had been considered to be a good layout to set a so-called T-S (target - substrate) distance from the center of each target to a vertical line drawn to the in-plane of the substrate to be held by the stage, e.g., above 190 mm, and also to arrange a sputtering surface (surface to be sputtered) of each of the target materials not to face the substrate.

The magnesium oxide film to be used as a tunnel barrier layer of the MTJ elements is sometimes subjected to anneal processing in a step after the film-forming steps, thereby improving the crystallinity. The annealing temperature has limitations from the viewpoint of limitations of the apparatus, and limitations due to the film arrangement of primary layers, and the like and, as a consequence, the temperature can only be raised up to about 700°C. Therefore, when a magnesium oxide film is formed by using the sputtering apparatus, the crystallinity thereof is improved so that a still larger MR ratio can be expected to be attained. Under the circumstances, the inventors of this invention have obtained the following finding upon strenuous efforts. The finding is that, when sputtering is performed by applying HF power to the MgO targets, neutral particles mainly of magnesium oxide among the sputtered particles that scatter from the targets, may be caused to reach the object (surfaces) of film formation, while minimizing the decrease in the sputtering energy possessed by the sputtering particles to the best extent possible. The finding is further that, due to migration of the sputtered particles, the crystallinity of rock salt structure can be still further improved, accompanied by better MR ratios.

### Prior Art Documents

### Patent Documents

Patent Document 1: JP-2011-058073 A

### SUMMARY OF THE INVENTION

### Problems that the Invention is to Solve

This invention has been made based on the above findings and has a problem of providing a sputtering apparatus in which an insulator film having a further improved crystallinity can be formed with better uniformity in the film thickness distribution.

### Means of Solving the Problems

In order to solve the above problems, the sputtering apparatus of this invention comprises: a vacuum chamber having disposed therein an insulator target; and a stage for holding thereon a substrate to be processed, the stage being disposed inside the vacuum chamber so as to face the insulator target. The apparatus further comprises: a driving means for driving to rotate the stage; a sputtering power source for applying HF power to the insulator target; and a gas introduction means for introducing a rare gas into the vacuum chamber. The sputtering apparatus is characterized in that a distance between the substrate and the sputtering surface of the insulator target is set to a range between 40 mm - 150 mm. By the way, as the insulator target, the target made of magnesium oxide may most preferably be used, but oxide targets made, e.g., of calcium oxide having a rock salt structure, barium oxide, strontium oxide, zirconium oxide, and the like, or fluoride targets such as magnesium fluoride, calcium fluoride, barium fluoride, strontium fluoride, zirconium fluoride and the like may also be used.

According to this invention, at the time of forming the insulator film by HF sputtering, an arrangement is employed in which the so-called T-S distance is set to a range of 40 mm - 150 mm. In this manner, among the sputtering particles that scatter from the target, the neutral particles mainly of the insulating materials (oxides) reach the substrate while retaining the (sputtering) energy possessed by the sputtered particles. As a result, due to migration of the sputtered particles, there can be obtained an insulator film whose crystallinity peculiar to the insulating materials has been further improved. When this insulator film is used as a tunnel barrier layer of the MTJ elements, it has been confirmed that the MR ratio can be made larger. If the T-S distance becomes larger than 150 mm, there cannot be obtained an insulator film with good crystallinity. In addition, lowering the HF power to be applied to the insulator target is not preferable because it may result in lowering the energy possessed by the sputtered particles. Further, by making the pressure inside the vacuum chamber higher to the range of 0.1Pa - 0.2 Pa than the range in the conventional example at the time of sputtering, the damage to the film by the negative ions shall preferably be reduced. At the same time, by making closer the T-S distance, the decrease in the energy due to the collision of the sputtered particles to the substrate shall preferably be kept to the minimum.

In this invention, preferably the insulator target is constituted by at least two target materials having a smaller area than the area of the substrate, said at least two target materials being disposed on an identical plane that is parallel with the substrate held by the stage while being respectively offset from the center of the substrate. According to this arrangement, the film thickness distribution at the time of respectively sputtering these at least two targets can be added together. In this manner, it becomes possible to adjust, to 1 σ < 1%, that in-plane film thickness distribution of the substrate (e.g., silicon wafer of Φ 300 mm in diameter) which is required in the film formation of the insulator film.

In addition, according to this invention, preferably the sputtering apparatus further comprises: such another metal target having a gettering effect as is disposed on said plane; and another sputtering power source for supplying DC power to said another target. According to this arrangement, thanks to the gettering effect at the time of sputtering said another target, the pressure inside the vacuum chamber can be reduced, to the quickest extent possible, down to about 5 x 10⁻⁷ Pa prior to the formation of the insulator film. There can thus be obtained, with good mass-productivity, an insulator film whose crystallinity peculiar to the insulating materials has been further improved. In this case, in order to prevent so-called cross-contamination between the insulator targets, the sputtering apparatus preferably further comprises a shielding means for selectively shielding those surfaces of the insulator target and of said another target which, respectively, face the surface of the substrate.

### BRIEF DESCRIPTION OF THE DRAWINGS

[FIG. 1] is a schematic view explaining the construction of a sputtering apparatus according to an embodiment of this invention.
[FIG. 2] is a schematic view showing the positional relationship, as seen in plan view (i.e., a view as seen from top), between the target and a shielding means.
[FIG. 3] is a graph showing the results of experiments to confirm the effects of this invention.
[FIG. 4] is a graph showing the results of experiments to confirm the effects of this invention.
[FIG. 5] is a graph showing the results of experiments to confirm the effects of this invention.

### MODES FOR CARRYING OUT THE INVENTION

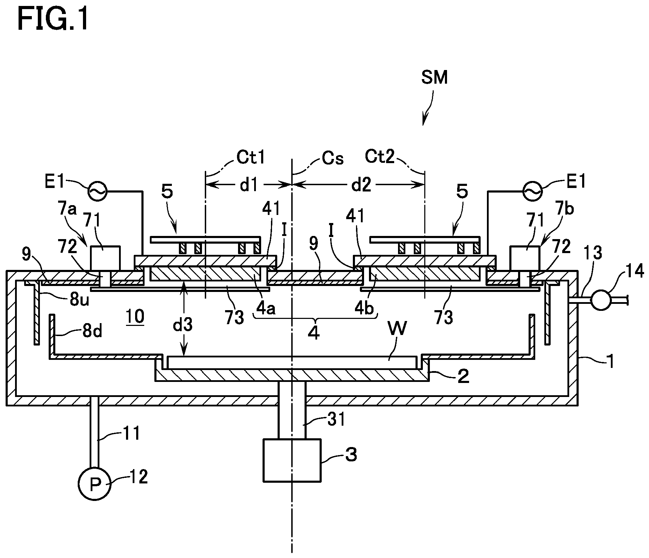

With reference to the accompanying drawings, a description will now be made of an embodiment of the sputtering apparatus of this invention on the basis of an example: in which a substrate W is supposed to be a silicon wafer of Φ 300 mm (in diameter); and in which an insulator target 4 is supposed to be a target made of magnesium oxide so that a magnesium oxide film as an insulator film is formed on the surface of the substrate. In the following, a description will be made by referring to FIG. 1 for the meaning of the terms indicating the directions, such as "upper" and "lower."

With reference to FIG. 1, reference characters SM refer to a sputtering apparatus according to this embodiment. The sputtering apparatus SM is provided with a vacuum chamber 1 which defines a processing chamber 10. To a bottom wall of the vacuum chamber 1, there is connected, through an exhaust pipe 11, a vacuum pump 12 so that the vacuum chamber 1 can be evacuated to a predetermined pressure (e.g., 1 x 10⁻⁶ Pa). To a side wall of the vacuum chamber 1, there is connected a gas introduction pipe 13 from a gas source (not illustrated) so that a rare gas whose flow rate has been controlled by a mass flow controller 14 can be introduced into the vacuum chamber 1. The gas introduction pipe 13 and the mass flow controller 14 constitute "gas introduction means" of this invention. In this case, preferably, the pressure inside the vacuum chamber 1 at the time of sputtering shall be set to a range of 0.02 Pa - 0.2 Pa, and the target potential (to be described later) shall be reduced, and also the energy decrease due to collision of the sputtered particles to the substrate W shall be restricted.

At a bottom portion inside the vacuum chamber 10, there is provided a stage 2 to hold thereon the substrate W. To the stage 2 there is connected a driving shaft 31 of a motor 3 as a driving means, the driving shaft 31 being provided in a manner to project into the processing chamber 10 by penetrating through the bottom wall of the vacuum chamber 1. It is thus so arranged that, at the time of film forming by sputtering, the stage 2 can be driven for rotation at a predetermined rotational speed with the center of the substrate W serving as the center of rotation. On an upper portion of the vacuum chamber 1 and in a manner to lie opposite to the stage 2, there is disposed a target 4 made of magnesium oxide in a manner to face the processing chamber 10. Alternatively, it may be so arranged that another HF power source is connected to the stage 2 so that a predetermined bias power may be applied to the stage 2 at the time of film formation.

The magnesium oxide target 4 is constituted by at least two (two in this embodiment) target materials 4a, 4b of circular shape as seen from top (in plan view) manufactured by a known method, the target materials being smaller in area than that of the substrate W. In this case, the area of the lower surface (surface to be subjected to sputtering) of both the target materials 4a, 4b before use may be appropriately set considering the splashing distribution of the sputtered particles at the time of sputtering, area of film-forming surface of the substrate W, and the like. Both the target materials 4a, 4b are disposed such that the center lines Cₜ₁, Cₜ₂ of both the target materials are respectively offset diametrically outward from the center line Cs of the substrate W that is held by the stage 2. In this case, one 4a of the target materials is disposed by setting the offset amount d1, depending on the area of the lower surface, at the time of non-use, such that part of the target material 4a protrudes outward beyond the outer circumference of the substrate W. With the above serving as a basis, the offset amount d2 of the other 4b of the target materials is set taking into consideration the film thickness distribution when a magnesium oxide film is formed on the substrate W. Further, the so-called T-S distance d3 between the lower surface at the time of non-use of both the target materials 4a, 4b and the substrate W is set to a range between 40 mm - 150 mm. If the T-S distance ds is above 150 mm, magnesium oxide film of good crystallinity cannot be obtained. The lower limit of the T-S distance d3 is set by considering securing the space for electric discharging, by considering the space for moving the shielding plate 73 of the shielding means 7a, 7b (to be described hereinafter), by considering the space for transferring the substrate W, and the like. It can be set, e.g., to the above-mentioned distance of 40 mm.

Both the target materials 4a, 4b are coupled, via a bonding material (not illustrated) such as indium, zinc, etc., to a backing plate 41 made of copper which is for cooling the target materials 4a, 4b at the time of film forming. In this state, the lower surfaces of both the target materials 4a, 4b at the time of non-use are fixed to the upper portion of the vacuum chamber 1 via an insulating plate I such that the lower surfaces at the time of non-use of both the target materials 4a, 4b are positioned on the same plane that is parallel with the substrate W. Above both the target materials 4a, 4b there are respectively disposed magnet units 5, 5 so as to generate tunnel-like leakage magnetic fields (not illustrated) in a lower space of the target 2. In this case, since the magnet units 5, 5 of a known configuration can be used, detailed description thereof is omitted. However, it is preferable to set the magnetic field strength of the horizontal component of the magnetic field at the lower surface (sputtering surface) of the target materials 4a, 4b to fall within a range of 1000G - 4000G. Both the target materials 4a, 4b have connected thereto an output from the HF power sources E1, E1 of a known construction, as sputtering power sources so that, at the time of sputtering, power of a predetermined frequency (e.g., 13.56 MHz) can be applied. In this case, the HF power to be applied is preferably set to a range of 0.1 kW - 0.6 kW so that the target electric potential can be increased. If the HF power is below 0.1 kW, it is not preferable because it will result in lowering of the energy possessed by the sputtered particles. Further, inside the vacuum chamber 1, upper and lower deposition-preventive plates 8u, 8d, 9 are disposed so that the sputtered particles are prevented from getting adhered to an inner wall surfaces of the vacuum chamber 1.

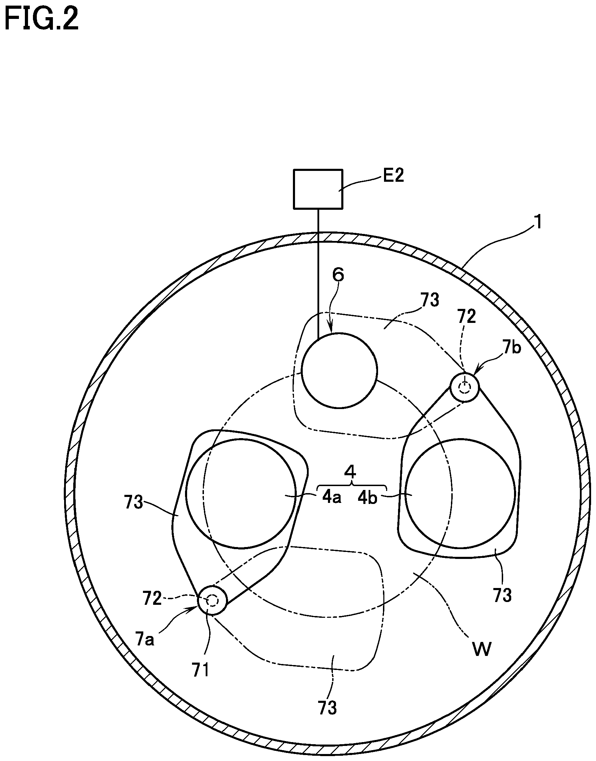

Further, with reference also to FIG. 2, on an upper portion of the vacuum chamber 1, there is disposed another target 6 made of titanium on the same plane as the lower surface of both the target materials 4a, 4b and in a manner to face the processing chamber 10. "Said another" target 6 is, though not particularly illustrated and described, coupled via a bonding material to a backing plate, in the same manner as in the above-mentioned target materials 4a, 4b and, in this state, is attached to the upper portion of the backing plate through an insulating plate I. An output from a DC power source (another sputtering power source), as a known "another" sputtering power supply, is connected to the target. Prior to the sputtering of the target materials 4a, 4b, the target 6 is sputtered to thereby form a titanium film on the deposition-preventive plates 8u, 8d, 9 and the like. As a result, due to a gettering effect of this titanium film, it is so arranged that the pressure inside the processing chamber 10 can be lowered as quickly as possible to about 5 x 10⁻⁷.

In addition, the upper portion of the vacuum chamber 1 is provided with two shielding means 7a, 7b. Each of the shielding means 7a, 7b has the same construction and is constituted by: a driving source 71 such as a motor, and the like; a driving shaft 72 which penetrates through an upper wall of the vacuum chamber 1 to thereby protrude into the processing chamber 10; and a shielding plate 73 which is coupled to the lower end of the driving shaft 72 and which has an area large enough to completely cover both the target materials 4a, 4b and "said another" target 6.

In case both the target materials 4a, 4b are sputtered, both the shielding plates 73 of the shielding means 7a, 7b are moved, as shown in imaginary lines in FIG.2, to a withdrawal position which is away from a lower portion of both the target materials 4a, 4b. At this time, "said another" target 6 can be completely covered by the shielding plate 73 of one of the shielding means 7b. In case "said another" target 6 is sputtered, both the shielding plates 73 of the shielding means 71, 7b are moved to the shielding position, as shown by solid lines in FIG. 2, under both the target materials 4a, 4b. At this time, both the target materials 4a, 4b are completely covered by both the shielding plates 73. According to this arrangement, cross-contamination among both the target materials 4a, 4b and "said another" target 6 can be effectively prevented. It is thus so arranged that an overall control is made by a control unit (not illustrated) on the operation of the sputtering apparatus SM such as the operation of the driving source 71, the operation of the vacuum pump 12, the introduction of the gas, the application of the electric power, and the like.

According to the above embodiment, when both the target materials 4a, 4b are sputtered under the above-mentioned conditions, among the sputtered particles scattered from each of both the target materials 4a, 4b, mainly the neutral particles of magnesium oxide will reach the substrate W while maintaining the (sputtering) energy possessed by the sputtered particles. As a result, there can be obtained a magnesium oxide film having a further improved crystallinity of the rock salt structure that is peculiar to magnesium oxide due to migration of the sputtered particles. In addition, there has been employed an arrangement in which "said another" target 6 made of titanium or tantalum is provided, and in which "said another" target can be subjected to sputtering prior to the film formation, e.g., of magnesium oxide film on the substrate W. Therefore, after having lowered, to the quickest extent possible, the pressure inside the processing chamber 10 to about 5 x 10⁻⁷ Pa, film formation of the magnesium oxide film can be made on the substrate W. Therefore, magnesium oxide film with further improved crystallinity of the rock salt structure can be obtained with good mass productivity. Furthermore, by forming films of a certain amount of metal material on the deposition preventive plates, an anode surface of RF sputtering can be secured, thereby enabling to maintain stable RF sputtering. By using the films formed in the above-mentioned manner as a tunnel barrier layer of the MTJ element, the MR ratio can be made still larger. In addition, by adding together the film thickness distribution when both the target materials 4a, 4b are respectively sputtered, it becomes possible to adjust the in-plane film thickness distribution of the substrate (e.g., silicon wafer of Φ 300 mm in diameter) to 1 σ < 1%

Next, in order to confirm the effect of this invention, the following experiments were performed by using the sputtering apparatus as shown in FIG. 1. In Experiment 1, as the substrate W, a silicon wafer of Φ 300 mm (in diameter) was used and, as the target materials 4a, 4b, the materials of Φ 165 mm (in diameter) were used, respectively. Further, as the sputtering conditions, the amount of introduction of argon gas and the exhaust speed of the vacuum pump were set so that the pressure in the processing chamber 10 at the time of sputtering was 0.1 Pa. The power applied from the HF power supply E1 was set to 0.50 kW. Then, the distance d1 between the center line Cₜ₁ of the target material 4a and the center line Cs of the substrate W was fixed to 80 mm. While varying the distance d2 between the center line Cₜ₂ of the target material 4b and the center line Cs of the substrate W, a magnesium oxide film was formed.

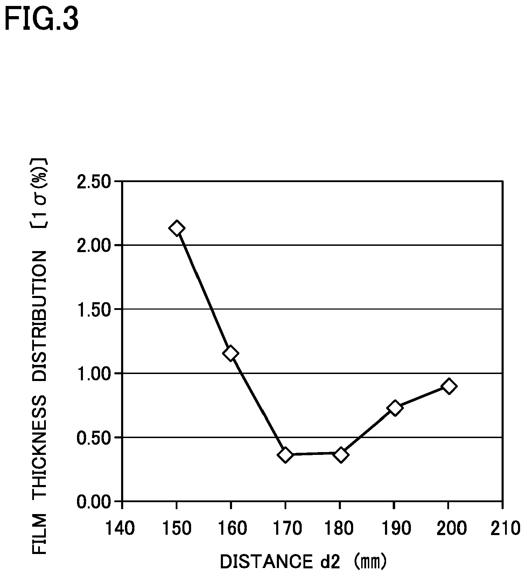

FIG. 3 is a graph showing the trend of the film thickness distribution when films of magnesium oxide were formed by varying the distance d2, by an amount of 10 mm at a time, within a range of 150 mm - 200 mm. According to this arrangement, it has been confirmed that, when the distance d1 was fixed to 80 mm, the film formation can be performed so as to keep the in-plane film thickness distribution of the substrate to be 1 σ < 1% if the distance d2 is set within a range of 165 mm - 200 mm. Further, it has been confirmed that the in-plane film thickness distribution of the substrate can be adjusted to 1 σ < 0.5% if the distance d2 is set within a range of 170 mm - 180 mm.

Next, in Experiment 2, after having formed CoFeB to a film thickness of 1.0 nm on the substrate W, by using the sputtering apparatus as shown in FIG. 1, a magnesium oxide film was formed to the film thickness of 0.8 nm, and further CoFeB was formed to a film thickness of 1.2 nm, and then a rate of change in magnetic resistance was measured. In this case, as the wafer W, a silicon wafer of Φ 300 mm (in diameter) was used, and target materials 4a, 4b of Φ 165 mm (in diameter) were used, respectively. The distance d1 between the center line Cₜ₁ of the target material 4a was fixed to 80 mm, and the distance d2 between the center line Cₜ₂ of the target material 4b and the center line Cs of the substrate W was set to 180 mm. The other sputtering conditions remained the same as those of Experiment 1. Then, the so-called T-S distance d3 was set to a long distance of 300 mm, and to a short distance which is shorter than 150 nm, i.e., 1/2 of the long distance.

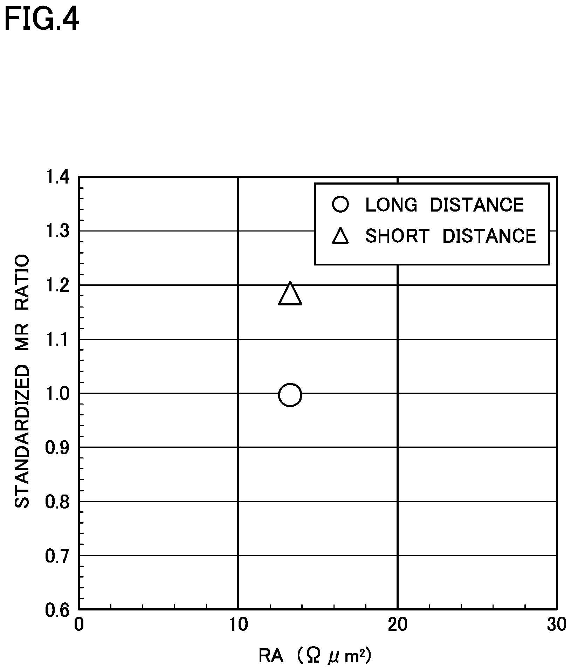

FIG. 4 is a graph showing a standardized MR ratio (rate of change in magnetic resistance) at the time of forming magnesium oxide film by varying the T-S distance. According to this graph, it has been confirmed that the MR ratio can be made larger as compared with the case where the T-S distance was a long distance of 300 mm (corresponding to the conventional example), by setting the T-S distance to a short distance. According to this, it has been found that, by setting the T-S distance to a short distance, magnesium oxide film with a further improved crystallinity can be obtained.

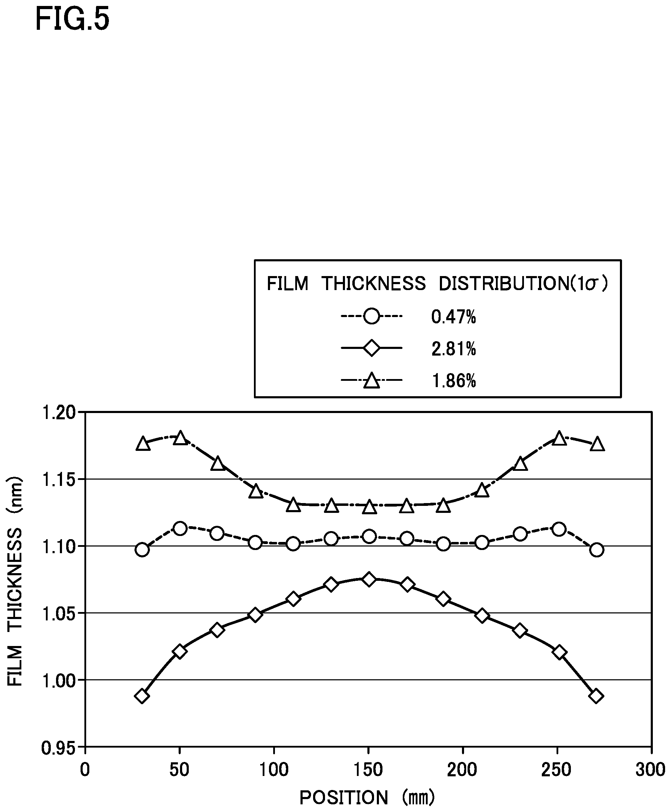

FIG. 5 is a graph showing the trend of the film thickness distribution when a magnesium oxide film was formed by adjusting the amount of film formation to be sputtered from the target materials 4a, 4b. According to this graph, the following have been found: that, in case the amount of film formation from the target material 4a is larger as compared with the amount of film formation from the target material 4b, the distribution trend becomes a downward projection as shown by a chain line, and the film thickness distribution becomes 1 σ 1.86 %; on the other hand that, in case the amount of film formation from the target material 4b is larger than the amount of film formation from the target material 4a, the distribution trend becomes an upward projection as shown by a solid line, and the film thickness distribution becomes 1 σ 2.81 %. By determining the amounts of film formation from the target materials 4a, 4b to the most appropriate balance, it has been confirmed that the film thickness distribution can be adjusted to 1 σ < 1% (0.47 %).

Description has so far been made of embodiments of this invention, but this invention shall not be limited to the above. Without departing from the scope of this invention, various modifications can be introduced. For example, as "said another" target 6, there may be used one made not only of titanium, but also made of tantalum. Further, the insulator target 4 need not be limited to the above-mentioned one made of magnesium oxide, but there may be used oxide targets made, e.g., of calcium oxide having a rock salt structure, barium oxide, strontium oxide, zirconium oxide, and the like, or fluoride targets such as magnesium fluoride, calcium fluoride, barium fluoride, strontium fluoride, zirconium fluoride and the like may also be used.

### Explanation of Reference Characters

- SM: sputtering apparatus
- W: substrate
- 1: vacuum chamber
- 2: stage
- 3: driving means
- 4: insulator target (target made of magnesium oxide)
- 4a, 4b: target material
- E1: sputtering power source
- 6: "another" target
- E2: "another" sputtering power supply
- 7a: shielding means

## Claims

1. In a sputtering apparatus comprising:
a vacuum chamber having disposed therein an insulator target;
a stage for holding thereon a substrate to be processed, the stage being disposed inside the vacuum chamber so as to face the insulator target;
the apparatus further comprising:
a driving means for driving to rotate the stage;
a sputtering power source for applying HF power to the insulator target; and
a gas introduction means for introducing a rare gas into the vacuum chamber;
**characterized in that** a distance between the substrate and the sputtering surface of the insulator target is set to a range between 40 mm - 150 mm.

2. The sputtering apparatus according to claim 1, wherein the insulator target is constituted by at least two target materials having a smaller area than the area of the substrate, said at least two target materials being disposed on an identical plane that is parallel with the substrate held by the stage while being respectively offset from the center of the substrate.

3. The sputtering apparatus according to claim 1 or 2, further comprising: such another metal target having a gettering effect as is disposed on said plane; and another sputtering power source for supplying DC power to said another target.

4. The sputtering apparatus according to claim 3, further comprising a shielding means for selectively shielding those surfaces of the insulator target and of said another target which, respectively, face the surface of the substrate.
